Europäisches Patentamt

European Patent Office

Office européen des brevets

(11) Publication number: **0 044 521**
**B1**

# EUROPEAN PATENT SPECIFICATION .

(45) Date of publication of patent specification: **20.03.85**

(51) Int. Cl.⁴: **B 65 G 59/02, H 05 K 13/04**

(21) Application number: **81105550.8**

(22) Date of filing: **15.07.81**

(54) **A process and feeding device to provide consecutive series of small objects on a single plane.**

(30) Priority: **22.07.80 IT 2359380**

(43) Date of publication of application:
**27.01.82 Bulletin 82/04**

(45) Publication of the grant of the patent:
**20.03.85 Bulletin 85/12**

(84) Designated Contracting States:
**AT CH DE FR GB IT LI NL SE**

(56) References cited:
**DE-A-2 716 330**
**DE-A-2 915 366**
**GB-A- 974 261**
**US-A-4 070 229**
**US-A-4 099 324**

(73) Proprietor: **FERCO S.p.A.**
**Via della Pusterla, 29**
**I-20020 Misinto (Milan) (IT)**

(72) Inventor: **Ferri, Beniamino**
**Via Rovani, 6**
**I-20052 Monza (Milan) (IT)**
Inventor: **Caimi, Giovanni**
**Via Volta, 101**
**I-21047 Saronno (Varese) (IT)**

(74) Representative: **Borella, Ada**
**Ing. A. Racheli & C. Viale San Michele del Carso,**
**4**
**I-20144 Milan (IT)**

Courier Press, Leamington Spa, England.

## Description

This invention relates to the feeding of small objects of difficult manual handling such as, for example, chip type electronic components, MELFs (Metal ELectronic Face bounding components), SOTs (i.e Small Outline Transistors) and integrated circuits provided with pins. According to the invention, objects are stacked in a series of magazines, a pusher acting upon one end of each magazine, while at the same time the opposite ends of the magazines are closed by a stop device so that the objects are moved against the stop device. The stop device is then moved away from the openings and the aligned surface of the objects is contacted with the planar surface on which the objects are to be applied.

Now, it should be specified that by successive series of objects it is here meant the simultaneous feeding of objects, each of which contained within its respective stack, that is the feeding of as many different objects as the stacks making up the magazines.

In DE—A—2 915 366 a process and related apparatus for feeding the objects stacked in a series of magazines are described, in which the pushers are spring operated. According to this document the stacks must resist to the pushing action. In fact, as the stop device is moved from the openings of the stacks, the objects at the top of the stacks can escape therefrom. Therefore the walls of the magazines must exert a restraining action which depends also on the heights of the stacks which change during operation.

Therefore, it is the object of the present invention to provide a process and an apparatus wherein the pushing action applied to the objects is different depending on the different thicknesses and tolerances of the objects and being independent from other conditions which can change during operation.

The foregoing object has been accomplished according to the process described in claim 1 and apparatus described in claim 2.

Other characteristics of the apparatus are mentioned in claims 3—7.

The invention will now be further explained with reference to exemplary embodiments as shown in the accompanying drawings, in which:

Fig. 1 is a sectional view showing a single magazine provided with a withdrawal device for using the plane as created by a stop device;

Figs. 2 and 3 show an embodiment of a device according to the invention, comprising an exemplary friction means for the pusher operation; and

Figs. 4 and 5 show another exemplary friction means for the pusher operation.

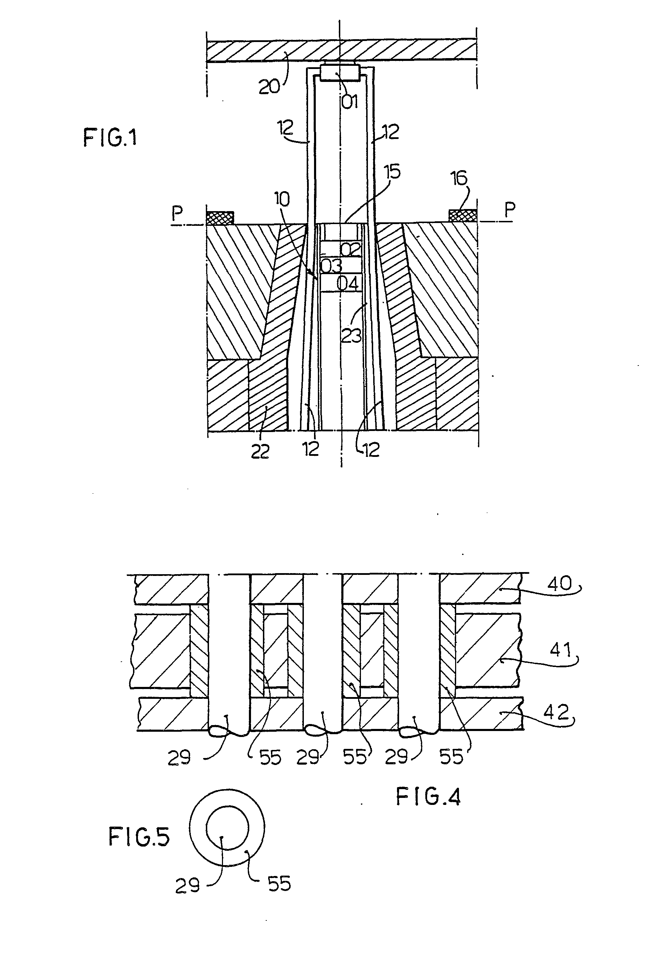

In Fig. 1 there is shown a support 22 for magazines 23, each of which contains a stack 10 of objects, such as 01, 02, . . ., 04. In this case the laying down plane is coincident with the withdrawal plane. As it will be seen in the drawings, these objects contained in the same stack, have different thicknesses and different thickness tolerances. At each withdrawal of a series of objects, a predetermined displacement for recovering the thickness of the missing object would significantly offset the final plane for the objects, since even minimal differences with respect to the rated value would sum up. It would also be impossible to take into account the object thickness tolerances, which are quite unexpected and could either add to or subtract from the previously specified error.

According to the present invention, stacks 10 of objects are pushed towards the free top opening 15 by a pusher.

Each of the magazines 23 containing the object stacks 10 have a free top opening 15, at which a stop grate 16 is provided, creating with its bottom surface a single stop surface for all of the object stacks 10. This plane is shown by line P—P and coincides with the laying down plane of the objects, as disclosed in the following.

The stop grate 16 will be such as to move from the position shown in Fig. 1, in which a full portion of the grate is between two top openings 15, to a position in which the openings are covered by the full portions of the grate 16.

The stop device can be provided, in addition to the stop grate 16, also with a full plate which will be then moved away, clearing the whole plane P—P containing the free openings 15 of the magazines.

The operation of the device according to the present invention is as follows: when at least some of the magazines 23 are filled with objects 01, 02, . . ., 04, the stop grate 16 is positioned at the free top openings 15. The pushers are operated so that the external surface of each object 01 contacts the stop grate 16. Therefore, the external surface of all of the objects 01 will lie on the plane P—P, which will make up a single plane.

Now, the stop grate 16 is moved so that said openings 15 are now free and the respective objects 01 can be withdrawn, so that the surface thereof contained in said plane P—P adheres against the planar surface onto which said objects will be applied. Next, all the objects 02 will be caused to contact the stop device and will then be fed as above described for the objects 01, and so on.

The application of the aligned objects on the reception surface therefore can be carried out, for example as shown in Fig. 1, by means of pliers 12 displacing said plane P—P parallel to itself, so as to contact the planar surface of board 20.

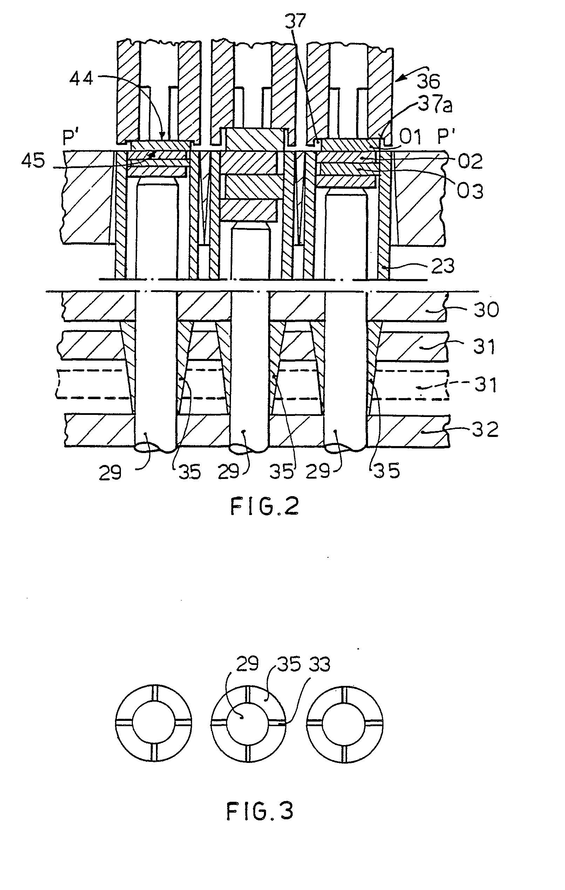

A second embodiment of the present invention is concerned with the case where the laying down plane is not coincident with the outwardly facing side 44 (Fig. 2) of the first objects 01 of the stacks 10 located at the free top opening 15 of the magazines 23, but with the side 45 opposite to the outwardly facing side.

This leads to further problems, in addition to that previously pointed out relating to the different tolerances of the objects having a same rated thickness; indeed, it is required to compensate for the difference in thickness of the various objects just as the latter are being aligned on a same plane.

A device enabling to create a single laying down plane corresponding to the object facing side opposite to the outwardly facing side is shown in Fig. 2. This figure shows the objects 01, 02, ..., 04 arranged in stacks 10 contained in magazines 23. The objects are urged by pusher means 29, as it will be explained in detail hereinafter, to a stop device 36 having cavities 37 therein, in which the first objects arranged in stacks 10 are inserted. Each of these cavities 37 are provided with an abutment 37a. The dimensions of cavities 37 depend on the dimensions and particularly on the thickness of the object which is to be handled, as shown in Fig. 2.

The stop device may also comprise pliers means provided with seats for withdrawing the objects and laying down the same on a single laying down plane.

The pusher means 29 insert in the friction adjusting unit comprising the plates 30, 31, 32.

Between said pushers 29 and plate 31 friction means are located as comprising, for example, conical bushings 35 having longitudinal slots 33 therein. An example of such a bushing 35 is shown in plan view in Fig. 3. The spacing between plate 30 and plate 32 is fixed, whereas the relative spacing thereof from plate 31 varies and is made fixed at the time of use depending on the amount of friction to be obtained. Said plate 31 closes said conical bushing 35 to a greater or lesser extent, thus exerting a higher or lower friction against the pushers 29, as shown in Fig. 2.

Another embodiment of the friction means is shown in Figs. 4 and 5. This friction means comprises a cylindrical bushing 55 of resilient material mounted around pusher 29 between two plates 40 and 42. The mutual spacing between these two plates determines the amount of friction to be provided, since it compresses, and accordingly deforms, said bushing 55. Plate 41 prevents the bushing deformation from occurring also outwardly of the pusher.

The operation of this second embodiment of the device is as follows: all of the magazines 23 arranged in the stack 10 are simultaneously upwardly pushed by the pushers 29. Therefore, the first object 01 of the stacks is inserted inside the cavities 37 in the stop device 36 and are stopped by the abutments 37a. As above mentioned, said cavities 37 have been differently configurated depending on the thickness of the objects, thus providing a single plane corresponding to line P'—P' (Fig. 2) along side face 45, which is the laying down plane for said objects. Of course, the object of smallest thickness will first reach the abutment 37a and then the pusher 29 corresponding thereto (that on the left side in Fig. 2) will slide, exerting friction against the friction means, while the other pushers will similarly fit the thickness of the various other objects.

## Claims

1. A process to provide small objects (01, ..., 04) on a single plane, wherein the objects are stacked in a series of magazines (23), a pusher (29) acting upon one end of each magazine (23) while at the same time the opposite ends (15b) of the magazines are closed by a stop device (16, 36) so that the objects (01, ..., 04) are moved against the stop device (16, 36), the stop device (16, 36) is then moved away from the openings (15b) and the aligned surface (P—P, P'—P') of the objects is contacted with the planar surface on which the objects are to be applied, characterized by the fact that different degrees of upward motion are applied to objects (01, ..., 04) in different stacks by means of pushers (29), which are simultaneously pushed upwardly, then, when the first object (01) of each stack contacts the stop device (16, 36) its respective pusher (29) slides with respect to cooperating friction means (35, 55), so as to carry out different degrees of upward motion depending on the different thicknesses and tolerances of the objects (01, ..., 04).

2. A device to provide small objects (01, ..., 04) on a single plane, wherein the objects are stacked in a series of magazines (23), said device comprising: a pusher (29) acting upon one end of each magazine, a movable stop device (16, 36) arranged to selectively close the opposite ends (15) of the magazines (23) and means (12, 36) to bring the aligned surface (P—P, P'—P') of the objects (01, ..., 04) in to contact with the planar surface on which the objects are to be applied, characterized by the fact that each pusher (29) is provided with a friction means (35, 55) which controls the movement of the pusher (29), such that different degrees of upward motion are applied to the objects (01, ..., 04), depending on the different thicknesses and tolerances of said objects (01, ..., 04).

3. A device according to claim 2, characterized in that said stop device is a grate (16) moving in its own plane.

4. A device according to claim 2, characterized in that said stop device (36) comprises pliers means.

5. A device according to claim 4, characterized in that the pliers means (36) is provided with cavities (37) for receiving the objects displaced by the pushers (19, 29), so that the aligned outer surface (P'—P') is comprised of those facing sides (45) of the first objects (01) in the stacks (10) of objects which are opposite to the outwardly-directed sides thereof.

6. A device according to claim 2, characterized in that the friction means comprises a conical bushing (35) provided with longitudinal slots (33), which may be closed to a greater or lesser extent.

7. A device according to claim 2, characterized in that said friction means comprises a cylindrical bushing (55) or resilient material which may be compressed to a greater or lesser extent.

## Revendications

1. Un procédé pour fournir de petits objets (01, ..., 04) sur une même surface, où les objets sont employés dans une série de magazins (23), en faisant agir un pousseur (29) sur une extrémité de chaque magazin (23), tandis qu'en même temps les extrémités opposées (15b) des magazins sont fermées par un dispositif d'arrêt (16, 36), de manière que les objets (01, . . ., 04) sont déplacés contre le dispositif d'arrêt (16, 36), le dispositif d'arrêt (16, 36) est éloigné des ouvertures (15b) et la surface alignée (P—P, P'—P') des objets est fait contacter avec la surface plane sur laquelle lesdits objets doivent être appliqués, caractérisé en ce qu'on applique aux objets (01, . . ., 04) dans les différentes piles, des poussées différenciées vers le haut au moyen de pousseurs (29) qui sont en même temps poussés vers le haut, puis, quand le premier objet (01) de chaque pile contacte le dispositif d'arrêt (16, 36) son pousseur correspondant (29) glisse par rapport au moyen de friction correspondant (35, 55), collaborant de façon que de différents degrés de poussée vers le haut sont exercés d'après les différentes épaisseurs et tolérances des objets (01, . . ., 04).

2. Un dispositif pour fournir de petits objets (01, . . ., 04) à une même surface, où les objets sont empilés dans une série de magazins (23), ledit dispositif comportant: un pousseuer (29) qui agit sur une extrémité de chaque magazin, un moyen d'arrêt mobile (16, 36) disposé pour fermer de manière sélective les extrémités opposées (15) des magazins (23) et des moyens (12, 36) pour amener la surface alignée (P—P, P'—P') des objets (01, . . ., 04) à contacte avec la surface plane sur laquelle les objets doivent être appliqués, caractérisé en ce que chaque pousseur (29) est pourvu d'un moyen à friction (35, 55) qui contrôle le mouvement du pousseur (29) de manière qu'on exerce de différents degrés de poussée vers le haut sur les objets (01, . . ., 04) d'après les différentes épaisseurs et tolérances desdits objets (01, . . ., 04).

3. Un dispositif selon la revendication 2, caractérisé en ce que le dispositif d'arrêt est une grille (16) qui se déplace sur son même plan.

4. Un dispositif selon la revendication 3, caractérisé en ce que ledit dispositif d'arrêt (36) comporte des moyens à pince.

5. Un dispositif selon la revendication 4, caractérisé en ce que le moyen à pince (36) est pourvu de cavités (37) destinées à recevoir les objets déplacés par les pousseurs (19, 29), de manière que la surface extérieure alignée (P'—P') résulte être constituée par les faces (45) des premiers objets (01) sur les piles (10) d'objets, qui sont opposées à ses faces tournées vers l'extérieur.

6. Un dispositif selon la revendication 2, caractérisé en ce que le moyen de transmission à friction est constitué par une douille conique (35) munie de fentes (33) longitudinales qui est plus ou moins fermée.

7. Un dispositif selon la revendication 2, caractérisé en ce que ledit moyen de transmission à friction est constitué par une douille cylindrique (55) de matière résiliente qui est plus ou moins comprimée.

## Patentansprüche

1. Verfahren zum Beschicken kleiner Gegenstände (01, . . ., 04) auf einer Ebene, auf der die Gegenstände in einer Reihe von Magazinen (23) aufgestapelt sind, wobei ein Schieber (29) auf ein Ende jedes Magazins (23) wirkt, während gleichzeitig die entgegengesetzten Enden (15b) der Magazine von einer Haltevorrichtung (16, 36) geschlossen sind, so daß die Gegenstände (01, . . ., 04) gegen die Haltevorrichtung (16, 36) verschoben werden, woraufhin die Haltevorrichtung (16, 36) von den Offnungen (15b) entfernt wird und die ausgerichteten Fläche (P—P, P'—P') der Gegenstände mit der flachen Oberfläche, auf der die Gegenstände angebracht werden müssen, in Berührung kommt, dadurch gekennzeichnet, daß die Gegenstände (01, . . ., 04) der verschiedenen Stapel, die gleichzeitig nach oben geschoben werden, unterschiedlich nach oben durch die Schieber (29) geschoben werden, wenn dann der erste Gegenstand (01) jedes Stapels die Haltevorrichtung (16, 36) berührt, läuft der entsprechende Schieber (29) gegenüber des entsprechenden damit zusammenarbeitenden Friktionsmittels (35, 55), so daß unterschiedliche Schubgrade nach oben aufgrund der unterschiedlichen Dicken und Toleranzen der Gegenstände (01, . . ., 04) ausgeübt werden.

2. Vorrichtung zum Beschicken kleiner Gegenstände (01, . . ., 04) auf einer Ebene, auf der die Gegenstände in einer Reihe von Magazin aufgestapelt sind, umfassend: einen Schieber (29) der auf ein Ende jedes Magazins wirkt, ein bewegliches Haltemittel (16, 36) zum wahlweisen Schliessen der entgegengesetzten Enden (15), der Magazine (23) und Mittel (12, 36), um die ausgerichtete Oberfläche (P—P, P'—P') der Gegenstände aufgebracht werden müssen, in Berührung zu bringen, dadurch gekennzeichnet, daß jeder Schieber (29) mit einem Friktionsmittel (35, 55) versehen ist, das die Bewegung des Schiebers (29) kontolliert, sodaß verschiedene Schubgrade nach oben auf die Gegenstände (01, . . ., 04) aufgrund der verschiedenen Dicken und Toleranzen der genannten Gegenstände (01, . . ., 04) ausgeübt werden.

3. Vorrichtung nach Anspruch 2, dadurch gekennzeichnet daß die Haltevorrichtung ein Gitter (16) ist, das sich in derselben Ebene bewegt.

4. Vorrichtung nach Anspruch 2 dadurch gekennzeichnet, daß die Haltevorrichtung (36) zangenartiges Mittel umfasst.

5. Vorrichtung nach Anspruch 4, dadurch gekennzeichnet daß zangenartiges Mittel (26) Sitze aufweist, um die von den Schiebern (19, 29) bewegten Gegenstände aufzunehmen, so daß die äussere ausgerichtete Oberfläche (P'—P') aus den Seiten (45) der ersten Gegenstände (01) auf dem Stapel (10) der Gegenstände gebildet ist, die den nach aussen gewandten Seiten gegenüber liegen.

6. Vorrichtung nach Anspruch 2, dadurch gekennzeichnet daß das Friktionsübertragungsmittel aus einer konischen Buchse (55) besteht, die mit Längsschlitzen (33) versehen ist und mehr oder weniger geschlossen wird.

7. Vorrichtung nach Anspruch 2, dadurch gekennzeichnet, dass das Friktionsübertragungsmittel aus einer zylindrischen Buchse (55) aus Isoliermaterial besteht, die mehr oder weniger zusammen gepresst ist.

FIG.1

P ——— P

20
01
12        12
15
16
10
02
03
04
23
22    12    12

FIG.4

40
41
42

29    55    29    55    29    55

FIG.5

29    55

1

FIG.2

FIG.3